# EUROPEAN PATENT APPLICATION

(11) **EP 4 598 283 A1**
(43) Date of publication of application: **06.08.2025**
(21) Application number: 25150107.8
(22) Date of filing: 02.01.2025
(51) Int. Cl.: H05K 1/14, H05K 3/36, H05K 3/46, H05K 1/11

(54) **NETWORK DEVICE HAVING PORT CONNECTIONS WITH REDUCED SIGNAL LOSS**

(30) Priority: 01.02.2024 US 202418430197
(71) Applicant: Arista Networks, Inc., Santa Clara, CA 95054 (US)
(72) Inventor: VAN HARTINGSVELDT, Elliott, San Jose (US); THOMPSON, Samuel, San Jose (US)
(74) Representative: Barton, Russell Glen

(57) **Abstract**

A network device or a system can include a printed circuit board, an integrated circuit mounted on a first side of the printed circuit board, a rigid-flex circuit having a first rigid portion, a second rigid portion, and a flexible portion joined between the first and second rigid portions, and port connectors mounted on the second rigid portion of the rigid-flex circuit. The first rigid portion of the rigid-flex circuit can be disposed on a second side, opposing the first side, of the printed circuit board. The rigid-flex circuit is configured to communicatively couple the integrated circuit to the port connectors. The network device can include alignment structures for positioning the printed circuit board and the rigid-flex circuit within a housing of the device.

## Description

This application claims priority to U.S. patent application No. 18/430,197, filed February 1, 2024, which is hereby incorporated by reference herein in its entirety.

### Background

A network device can include one or more processors mounted on a printed circuit board. The one or more processors can be connected to corresponding port connectors of the network device. It can be challenging to connect the one or more processors to the port connectors. Conventional mechanisms for connecting a processor to various port connectors in a network device often exhibit poor signal loss behavior. It is within such context that the embodiments herein arise.

### Brief Description of the Drawings

FIG. 1 is a diagram of an illustrative network device having input-output ports in accordance with some embodiments.
FIG. 2 is a side view of an illustrative network device having a rigid-flex circuit for coupling an integrated circuit to corresponding port connectors in accordance with some embodiments.
FIG. 3A is a side view of illustrative stacked port connectors in accordance with some embodiments.
FIG. 3B is a front view of illustrative stacked port connectors in accordance with some embodiments.
FIG. 3C is a front view of an illustrative network device having an array of ports in accordance with some embodiments.
FIG. 4 is a top (plan) view of an illustrative via pattern for connecting the integrated circuit to the rigid-flex circuit in accordance with some embodiments.
FIG. 5A is a side view of an illustrative network device having alignment posts for aligning the printed circuit board and the rigid flex circuit in accordance with some embodiments.
FIG. 5B is a top (plan) view of an illustrative pattern of openings for accommodating the alignment posts of FIG. 5A in accordance with some embodiments.
FIG. 6A is a side view of an illustrative network device having two sets of alignment posts for separately aligning the printed circuit board and the rigid flex circuit in accordance with some embodiments.
FIG. 6B is a top (plan) view of an illustrative pattern of openings for accommodating the two sets of alignment posts of FIG. 6A in accordance with some embodiments.
FIG. 7 is a top (plan) view showing a single rigid-flex circuit configured to provide signal connection paths between the integrated circuit and the corresponding port connectors in accordance with some embodiments.
FIG. 8 is a top (plan) view showing multiple rigid-flex circuits configured to provide signal connection paths between the integrated circuit and the corresponding port connectors in accordance with some embodiments.
FIG. 9 is a side view of an illustrative network device having an integrated circuit that is coupled to port connectors via one or more rigid-flex circuits having minimal bending in accordance with some embodiments.
FIG. 10 is a diagram showing illustrative hardware components within a data processing system in accordance with some embodiments.

### Detailed Description

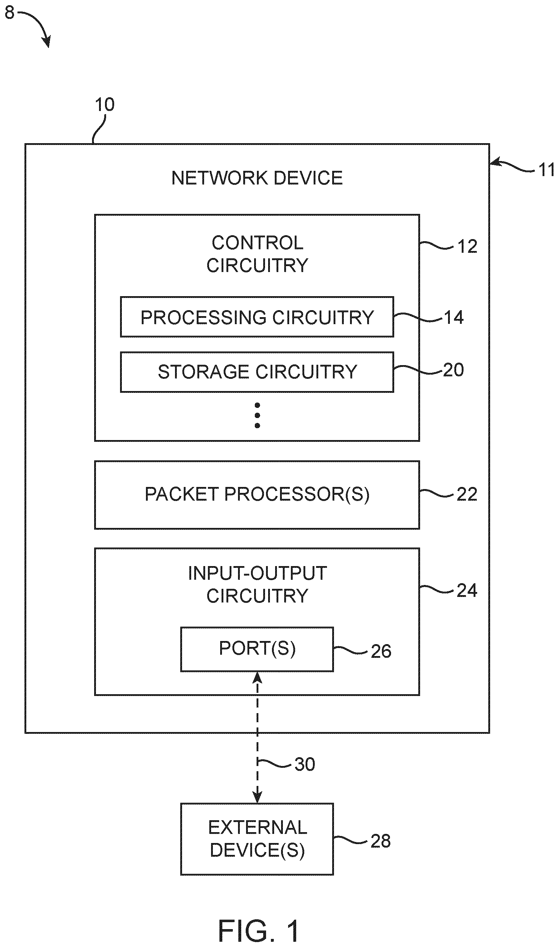

FIG. 1 is a diagram of a network device such as network device 10. Network device 10 may have a main printed circuit board (PCB), one or more processors mounted on a first side of the printed circuit board, first port connectors mounted on the first side of the printed circuit board, and second port connectors mounted on a second side of the printed circuit board opposing the first side. The one or more processors may be communicatively coupled to the first and second port connectors via conductive traces formed within the printed circuit board. To accommodate more port connectors within device 10, the one or more processors may be coupled to additional port connectors through a rigid-flex circuit.

The rigid-flex circuit can include a first rigid portion mounted on the second side of the printed circuit board, a second rigid portion, and a flexible portion joined between the first rigid portion and the second rigid portion. The first rigid portion of the rigid-flex circuit may be communicatively coupled to the one or more processors through conductive vias formed in the printed circuit board. The first rigid portion of the rigid-flex circuit may be mounted directly opposite the one or more processors mounted on the other side of the printed circuit board. The first rigid portion of the rigid-flex circuit may be coupled to the second side of the printed circuit board via conductive elastomer (as an example). Additional port connectors such as third port connectors may be mounted on a first side of the second rigid portion and fourth port connectors may be mounted on a second side of the second rigid portion. The flexible portion of the rigid-flex circuit can be bent so that the third and fourth port connectors are disposed above or under the first and second port connectors. Coupling the one or more processors to the third and fourth port connectors in this way can be technically advantageous and beneficial for reducing signal loss and for improving signal integrity between the one or more processors and the corresponding port connectors.

In the example of FIG. 1, an illustrative system 8 may include one or more network devices 10. Each network device 10 may be a switch (e.g., a single-layer (Layer 2) switch or a multi-layer (Layer 2 and Layer 3) switch), a router or gateway, a bridge, a hub, a repeater, a firewall, a wireless access point, a network management device that manages one or more other network devices, a device serving other networking functions, a device that includes a combination of these functions, or other types of network devices. Multiple such network devices 10 (e.g., of different types and/or having different functions) in system 8 may be present and interconnected therebetween and with other network devices in other network portions to form a communications network that forwards network traffic (e.g., as frames, as packets, and/or in other forms) between end hosts.

Network device 10 may include control circuitry 12 having processing circuitry 14 and storage circuitry 20, one or more packet processors 22, and input-output interfaces 24 disposed within a housing 11 of network device 10. The housing 11 may include an exterior cover (e.g., a plastic exterior shell, a metal exterior shell, or an exterior shell formed from other rigid or semirigid materials) that provides structural support and protection for the components of network device 10 mounted within the housing. In one illustrative arrangement, network device 10 may be part of a modular network device system (e.g., a modular switch system having removably coupled modules usable to flexibly adjust system capabilities such as adjust the network traffic processing capabilities by changing the number of processors, memory, and/or other hardware components, adjust the number of ports, add or remove specialized functionalities, etc.). In another illustrative arrangement, network device 10 may be a fixed-configuration network device (e.g., a fixed-configuration switch having a fixed number of ports and/or a fixed hardware configuration).

Processing circuitry 14 may include one or more processors or processing units based on central processing units (CPUs), graphics processing units (GPUs), microprocessors, general-purpose processors, host processors, microcontrollers, digital signal processors, programmable logic devices such as a field programmable gate array device (FPGA), application specific system processors (ASSPs), application specific integrated circuit (ASIC) processors, and/or other processor architectures. Processing circuitry 14 may run (execute) a network device operating system and/or other software/firmware that is stored on storage circuitry 20.

Storage circuitry 20 may include one or more non-transitory (tangible) computer readable storage media that stores the operating system software and/or any other software code, sometimes referred to as program instructions, software, data, instructions, or code. As an example, network device control plane functions may be stored as (software) instructions on the one or more non-transitory computer-readable storage media (e.g., in portion(s) of memory circuitry 20 in network device 10). The corresponding processing circuitry (e.g., one or more processors of processing circuitry 14 in network device 10) may process or execute the respective instructions to perform the corresponding operations. Storage circuitry 20 may be implemented using non-volatile memory (e.g., flash memory or other electrically-programmable read-only memory configured to form a solid-state drive), volatile memory (e.g., static or dynamic random-access memory), hard disk drive storage, and/or other storage circuitry. Storage circuitry 20 is therefore sometimes referred to as memory circuitry. Processing circuitry 14 and storage circuitry 20 as described above may sometimes be referred to collectively as control circuitry 12 implementing a "control plane" of network device 10.

For example, processing circuitry 14 may execute network device control plane software such as operating system software, routing policy management software, routing protocol agents or processes, routing information base agents, and other control software, may be used to support the operation of protocol clients and/or servers (e.g., to form some or all of a communications protocol stack such as the Transmission Control Protocol (TCP) and Internet Protocol (IP) stack), may be used to support the operation of packet processor(s) 22, may store packet forwarding information, may execute packet processing software, and/or may execute other software instructions that control the functions of network device 10 and the other components therein.

Packet processor(s) 22 may be used to implement a data plane or forwarding plane of network device 10. Packet processor(s) 22 may include one or more processors or processing units based on central processing units (CPUs), graphics processing units (GPUs), microprocessors, general-purpose processors, host processors, microcontrollers, digital signal processors, programmable logic devices such as a field programmable gate array device (FPGA), application specific system processors (ASSPs), application specific integrated circuit (ASIC) processors, and/or other processor architectures. Packet processor 22 may receive incoming data packets via input-output circuitry 24, parse and analyze the received data packets, process the packets based on packet forwarding decision data (e.g., data in a forwarding information base) and/or in accordance with network protocol(s) or other forwarding policy, and forward (or drop) the data packet accordingly. The packet forwarding decision data may be stored on a portion of storage circuitry 20 and/or other memory circuitry integrated as part of or separate from packet processor 22.

To interact with external devices, external systems, and/or users, network device 10 may include input-output circuitry (interface) 24 formed from corresponding input-output devices (sometimes referred to as interface circuitry). Input-output interface circuitry 24 may include different types of communication interfaces such as Ethernet interfaces (e.g., formed from one or more Ethernet ports), optical interfaces (e.g., formed from removable optical modules containing optical transceivers), Bluetooth interfaces, Wi-Fi interfaces, and/or other network interfaces for connecting device 10 to the Internet, a local area network, a wide area network, a mobile network, generally network device(s) in these networks, and/or other computing equipment (e.g., end hosts, server equipment, user devices, etc.). As an example, some input-output circuitry 24 (e.g., those based on wireless communication) may be implemented using wireless communications circuitry (e.g., antennas, transceivers, radios, etc.).

As another example, some input-output circuitry 24 (e.g., those based on wired communication) may be implemented as physical ports, sometimes referred to as sockets. These physical ports may be configured to physically couple to and/or electrically connect to corresponding mating connectors of external components or equipment (e.g., pluggable optical transceiver modules). Different ports may have different form-factors to accommodate different cables, different modules, different devices, or generally different external equipment. In the example of FIG. 1, input-output circuitry 24 may include one or more ports 26. Ports 26 may be physically coupled to one or more external device(s) 28. An external device 28 can have an extension module configured to be inserted or plugged into port 26 as indicated by arrow 30.

In other illustrative arrangements, one or more components such as packet processor 22 may be omitted from device 10 and device 10 may generally be a computing device with other non-networking functions. In other words, port 26 may be contained within a non-networking computing device 10 or generally a computing or electronic system that conveys electrical signals using port 26 with external equipment.

Configurations in which ports 26 include port connectors configured to receive and mate with an edge card connector of a transceiver module are sometimes described herein as an illustrative example. In other illustrative examples, ports 26 may include any type of port connectors configured to mate with edge card connectors for other components (e.g., components utilizing Peripheral Component Interconnect (PCI) connectors, Peripheral Component Interconnect Express (PCIE) connectors, accelerated graphics port (AGP) connectors, Ethernet connectors, Thunderbolt connectors, high-definition multimedia interface connectors, etc.) and/or other types of port connectors configured to mate with non-edge-card connectors.

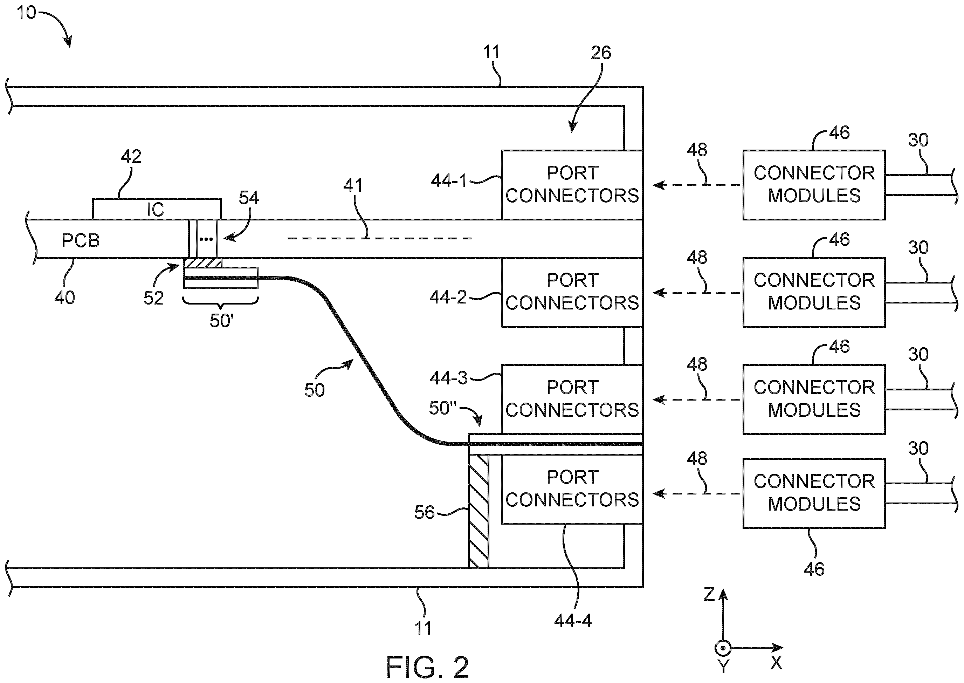

FIG. 2 is a side view of network device 10 that includes a rigid-flex circuit for coupling an integrated circuit to corresponding port connectors. As shown in FIG. 2, network device 10 may include a printed circuit board (PCB) such as printed circuit board 40, an integrated circuit (IC) such as integrated circuit 42, input-output port connectors such as port connectors 44-1, 44-2, 44-3, and 44-4, and a rigid-flex circuit such as rigid-flex circuitry 50. These various components can be secured within exterior housing 11 of network device 10. Printed circuit board 40 is sometimes referred to as a main board or a main PCB. Integrated circuit 42 can be mounted to a first side (surface) of printed circuit board 40 via an array of solder balls (e.g., a ball grid array) or other surface-mount mechanism. Integrated circuit 42 can be an integrated circuit die or an integrated circuit package (e.g., an integrated circuit chip mounted on a package substrate within a package housing) and can generally represent one or more processors within device 10, such as a packet processor (as an example).

First port connectors 44-1 can be mounted to the first side of printed circuit board 40, whereas second port connectors 44-2 can be mounted to a second side, opposing the first side, of printed circuit board 40. First port connectors 44-1 can be coupled to the first side of PCB 40 via an array of solder balls or other surface-mount mechanism. Similarly, second port connectors 44-2 can be coupled to the second side of PCB 40 via an array of solder balls or other surface-mount mechanism. Integrated circuit (IC die or package) 42 may be communicatively (communicably) coupled to first port connectors 44-1 and second port connectors 44-2 via conductive traces 41 formed within PCB 40.

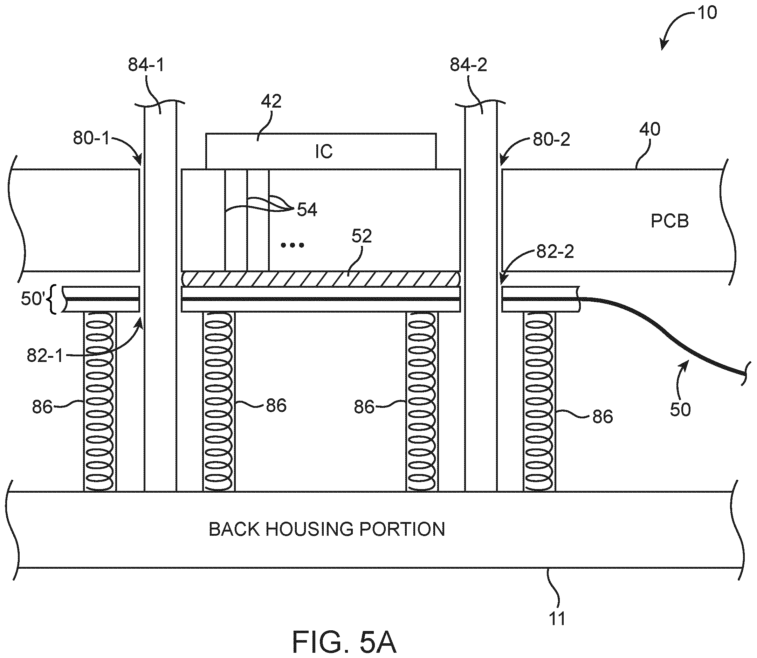

In accordance with some embodiments, integrated circuit 42 may be communicatively (communicably) coupled to additional port connectors such as third port connectors 44-3 and fourth port connectors via rigid-flex circuit 50. Rigid-flex circuit 50 is sometimes referred to as a flex or flexible interconnect, a rigid-flex assembly, or a daughter card. Rigid-flex circuit 50 has rigid portions such as a first rigid portion 50' and a second rigid portion 50" and has a flexible portion joined between the first rigid portion 50' and the second rigid portion 50". First rigid portion 50' may be mounted on the second side (surface) of printed circuit board 40. First rigid portion 50' may be coupled to the second side of printed circuit board 40 via conductive elastomeric material 52 (as an example). The conductive elastomeric material 52 is sometimes referred to as conductive elastomer. The use of conductive elastomer 52 is exemplary. If desired, other ways for mounting rigid-flex circuit 50 to a surface of PCB 40 can be employed. At least a portion of rigid portion 50' is disposed directly under the footprint of integrated circuit 42. As an example, the footprint of rigid portion 50' may be partially overlapping with the footprint of integrated circuit 42 (as illustrated in the embodiment of FIG. 2). As another example, the footprint of integrated circuit 42 may be located or positioned entirely within the footprint of rigid portion 50' (as shown in the embodiment of FIG. 5A). As another example, the footprint of rigid portion 50' may be located or positioned entirely within the footprint of integrated circuit 42.

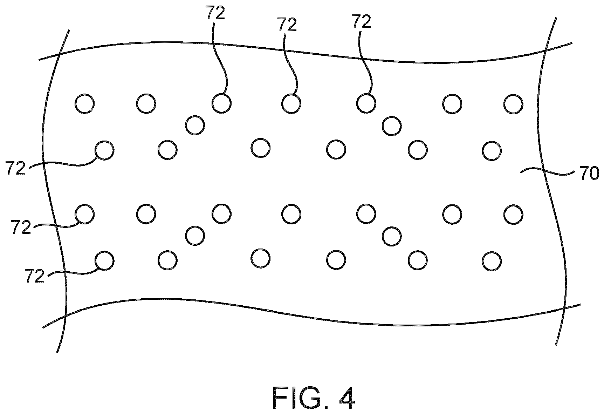

Integrated circuit 42 may be communicatively coupled to corresponding conductive pads on first rigid portion 50' through conductive vias 54 formed within printed circuit board 40. FIG. 4 is a top (plan) view showing an illustrative via pattern of the conductive vias 54. As shown in FIG. 4, layer 70 can represent one or more layers of printed circuit board 40, and holes 72 can represent conductive vias 54 formed through the one or more layers of PCB 40. The via pattern of FIG. 4 is exemplary. In general, the via pattern can have an irregular pattern, a regular pattern, a partially regular or repeating pattern, or other suitable patterns. The conductive pads on first rigid portion 50' may have a similar or identical pattern as the via pattern shown in FIG. 4. The conductive pads on the second (bottom) side of PCB 40 coupled to vias 54 may have a similar or identical pattern as the via pattern shown in FIG. 4.

In the example where rigid portion 50' is mounted to the underside of PCB 40 via conductive elastomer 52, there may be no solder mask at the underside of PCB 40 facing rigid portion 50' or on the top (upper) side of rigid portion 50' where conductive elastomer 52 makes contact. Conductive elastomer 52 may be conductive only in regions where the material is physically compressed. The compression of conductive elastomer 52 can be achieved by plated pads pushing on elastomer 52 from both sides (e.g., plated pads formed on the bottom surface of PCB 40 and plated pads formed on the top surface of rigid portion 50' collectively applying compressive force on elastomer 52). A solder mask can be omitted in these areas to ensure a controlled amount of compression. The plated pads on the second side of PCB 40 facing the first rigid portion 50' and the plated pads on the first rigid portion 50' facing PCB 40 may be formed by employing an electroless nickel immersion gold (ENIG) process, an electroless nickel electroless palladium immersion gold (ENEPIG) process, or other process for avoiding corrosion and oxidation of the plated pads.

Third port connectors 44-3 may be mounted on a first side (surface) of rigid portion 50" via an array of solder balls or other surface-mount mechanism. Similarly, fourth port connectors 44-4 can be mounted on a second side (surface) of rigid portion 50" via an array of solder balls or other surface-mount mechanism. The flexible portion of rigid-flex circuit 50 allows the additional port connectors 44-3 and 44-4 to be positioned anywhere in device 10 without the need for a mezzanine connector or near-ASIC connectors. Port connectors 44-1, 44-2, 44-3, and 44-4 may represent physical port connectors for the input-output ports 26 of device 10. Second rigid portion 50" may be secured to housing 11 via a support structure 56. The bottom (lower) portion of network device 10 on which support structure 56 is attached is sometimes referred to as a backing plate or a back housing portion.

Port connectors 44-1 may include one or more rows of port connectors. In embodiments where port connectors 44-1 represent *stacked* port connectors, port connectors 44-1 may include two or more rows of port connectors oriented vertically with respect to one another. Similarly, port connectors 44-2 may represent one or more rows of port connectors. In embodiments where port connectors 44-2 represent *stacked* port connectors, port connectors 44-2 may include two or more rows of port connectors oriented vertically with respect to one another. Similarly, port connectors 44-3 may represent one or more rows of port connectors. In embodiments where port connectors 44-3 represent *stacked* port connectors, port connectors 44-3 may include two or more rows of port connectors oriented vertically with respect to one another. Similarly, port connectors 44-4 may represent one or more rows of port connectors. In embodiments where port connectors 44-4 represent *stacked* port connectors, port connectors 44-4 may include two or more rows of port connectors oriented vertically with respect to one another.

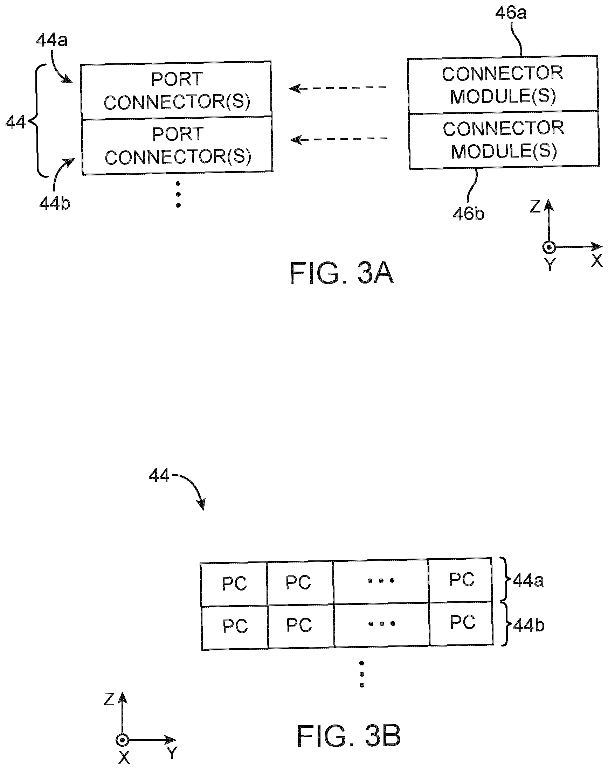

FIG. 3A is a side view of stacked port connectors in accordance with some embodiments. As shown in FIG. 3A, stacked port connectors 44 can include a first group of one or more port connectors 44a stacked on top of a second group of one or more port connectors 44b. The first group of one or more port connectors 44a can be configured to receive external connector module(s) 46a, whereas the second group of one or more port connectors 44b can be configured to receive external connector module(s) 46b. Details of the external connector modules are described in more detail below. FIG. 3B is a front view of illustrative stacked port connectors 44. As shown in FIG. 3B, stacked port connectors 44 can include a first group (row) of port connectors (labeled as "PC" in FIG. 3B) stacked on top of a second group (row) of port connectors. The example of FIG. 3B in which stacked port connectors 44 include at least two rows of port connectors stacked vertically with respect to one another is illustrative. In general, stacked port connectors 44 can include two or more rows of port connectors stacked on top of one another, three or more rows of port connectors stacked on top of one another, four or more rows of port connectors stacked on top of one another, or five or more rows of port connectors stacked on top of one another.

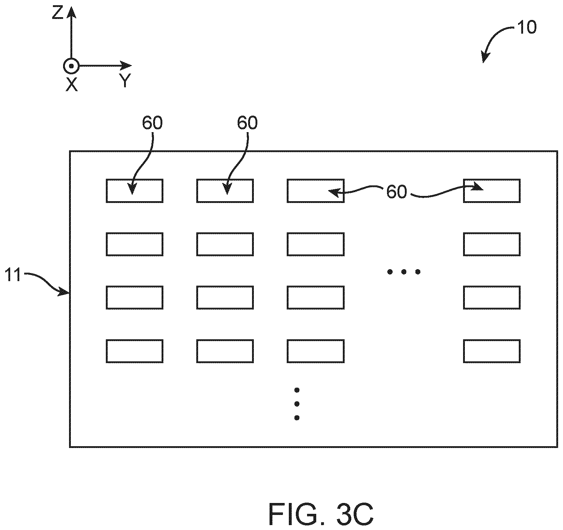

FIG. 3C is a front view of network device 10 having an array of openings 60. The array of openings 60 may correspond to openings for the various port connectors 44 described in connection with FIG. 2. The array of openings 60 may correspond to openings for front panel ports of network device 10 (as an example). As shown in FIG. 3C, network device 10 may include four or more rows of port openings, five to ten rows of port openings, or more than 10 rows of port openings. Each row in the array can include five to ten port openings, 10 to 20 port openings, 20 to 30 port openings, or more than 30 port openings.

Referring back to FIG. 2, the various port connectors 44 can be configured to mate with or receive connector modules 46, as shown by arrows 48. These external connector modules 46 may include (electrical or optical) transceiver modules such as pluggable or removable transceiver modules (e.g., small form-factor pluggable (SFP) modules, quad small form-factor pluggable (QSFP) modules, QSFP double density (QSFP-DD) modules, octal small form-factor pluggable (OSFP) modules, etc.) or other network interface modules, may include removable network modules that expand the functionalities of network device 10 (e.g., an asynchronous transfer mode network module, an Ethernet network module, a router or virtual private network module, a network services module, a route processor module, etc.), or may include any other suitable connector modules. As an example, an optical or electrical transceiver module, when plugged into or received in port connectors 44, may enable network device 10 to be coupled to another network device 10 through a (high-speed) fiber-optic cable or a (high-speed) copper cable 30. These examples are illustrative. If desired, external connector modules 46 can include other types of backplane connectors, including but not limited to: Versa Module Europa (VME) connectors, compact Peripheral Component Interconnect (PCI) or compact PCI Express connectors, Small Computer System Interface (SCSI) connectors, Advanced Telecom Computing Architecture (ATCA) connectors, Virtual Path Cross-Connector (VPX) connectors, or a combination of these connectors, just to name a few. Providing a signal path between integrated circuit 42 to port connectors 44-3 and 44-4 via a rigid-flex circuit 50 is technically advantageous and beneficial due to improved signal loss behavior for signals traversing flexible material as opposed to signals traversing a conventional fiberglass printed circuit board.

The example of FIG. 2 in which rigid-flex circuit 50 is mounted on the bottom (lower) surface of printed circuit board 40 without the use of any alignment structures is illustrative. FIG. 5A shows an embodiment of network device 10 having alignment structures for physically aligning the rigid-flex circuit 50 to the printed circuit board 40. As shown in the side view of FIG. 5A, network device 10 can include alignment structures such as alignment posts 84-1 and 84-2 secured to and extending from back housing portion 11. The alignment posts are sometimes referred to as alignment pins or alignment studs. The alignment posts can have the same size (diameter) or can have different sizes (diameters).

In the example of FIG. 5A, alignment post 84-1 can be inserted through a hole 80-1 in printed circuit board 40 and a hole 82-1 in the first rigid portion 50' of the rigid-flex circuit 50. Similarly, alignment post 84-2 can be inserted through a hole 80-2 in printed circuit board 40 and a hole 82-2 in the first rigid portion 50' of the rigid-flex circuit 50. To help apply compression to conductive elastomer 52, coil spring structures such as coil springs 86 can be provided between back housing portion 11 and rigid portion 50'. As an example, coil springs 86 can be configured to apply an upwards force of 200 pounds or more to achieve an appropriate amount of pressure on the conductive pads that are in contact with conductive elastomer 52. The use of coil springs 86 is merely illustrative. If desired, other types of compressive applicator structures such as a screw-type applicator, a pneumatic compressor, or a hydraulic compressor can be employed.

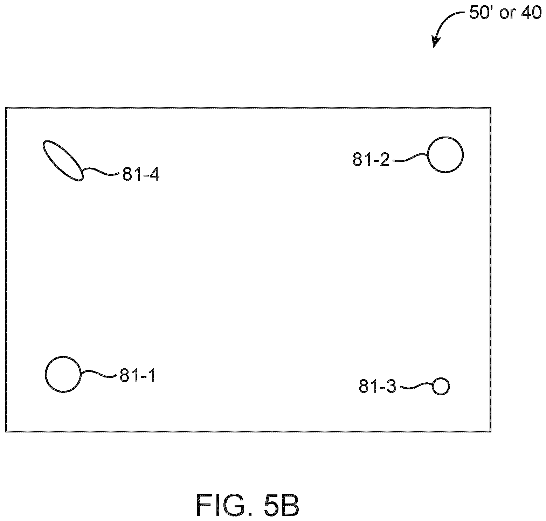

The hole pattern for accommodating the alignment posts in PCB 40 and rigid portion 50' may be identical or similar. FIG. 5B is a top (plan) view showing an illustrative pattern of through holes in PCB 40 or rigid portion 50' for receiving the alignment posts. As shown in FIG. 5B, there can be at least four holes 81-1, 81-2, 81-3, and 81-4. The holes 81 of FIG. 5B can represent any of holes 80-1 and 80-2 through PCB 40 and/or any of holes 82-1 and 82-2 through rigid portion 50' shown in FIG. 5A. Hole 81-3 may be a circular through hole with a tight tolerance for fully preventing translation (e.g., hole 81-3 may be just wide enough to receive the corresponding alignment post). Hole 81-4 may be a non-circular or oval/elliptical shaped slot with a tight tolerance for preventing rotation (e.g. slot 81-4 may be oriented normal to the direction of rotation). The two remaining holes 81-1 and 81-2 may be circular through holes with a loose tolerance (e.g., holes 81-1 and 81-2 may be relatively wide for receiving corresponding alignment posts for ensuring that the vertical force is evenly distributed across rigid portion 50' of the rigid-flex circuit 50). The loose tolerance holes 81-1 and 81-2 are generally wider in terms of diameter than that of the tight tolerance hole 81-3. When four holes 81 are employed, then four alignment posts 84 can be included within network device 10. The example of FIG. 5B having four alignment holes is illustrative. In other embodiments, printed circuit board 40 and/or rigid portion 50' can have at least three alignment holes of the same size or different sizes, at least two alignment holes of the same size or different sizes, at least one alignment hole, or more than four holes of the same size or different sizes.

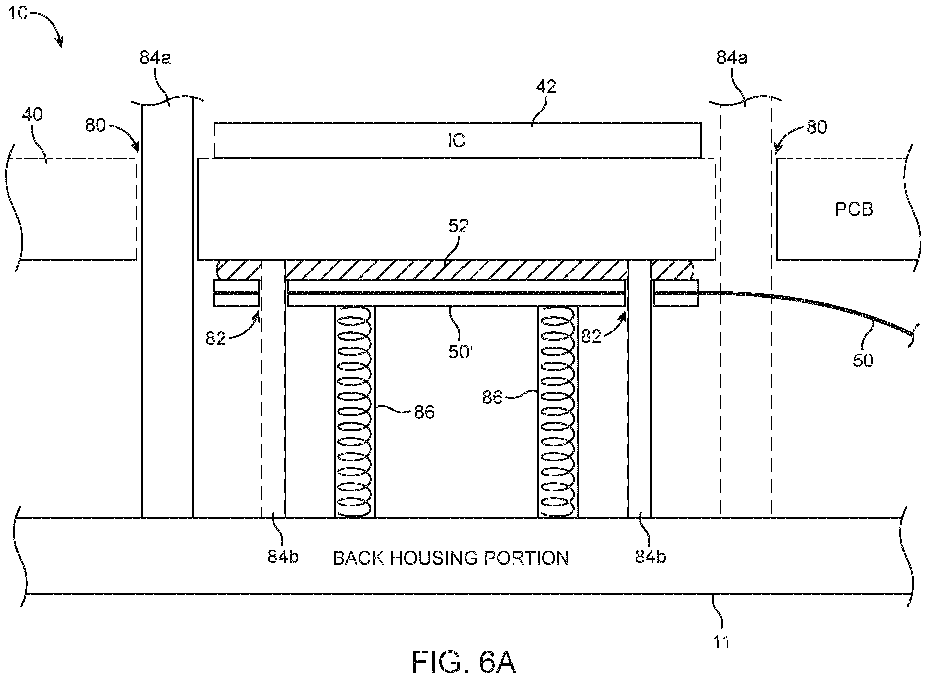

The example of FIG. 5A in which alignment post 84-1 is inserted through corresponding hole 80-1 in PCB 40 and hole 82-1 in rigid portion 50' is illustrative. FIG. 6A shows another embodiment of network device 10 having two different sets of alignment posts for separately aligning printed circuit board 40 and rigid-flex circuit 50 within the device housing 11. As shown in the side view of FIG. 6A, network device 10 can include a first set of alignment structures including alignment posts 84a and a second set of alignment structures including alignment posts 84b. Alignment posts 84a may be secured to and extend from back housing portion 11 and can be inserted through holes 80 in printed circuit board 40. Alignment posts 84b may also be secured to and extend from back housing portion 11 and can be inserted through holes 82 in rigid portion 50'. The alignment posts are sometimes referred to as alignment pins or alignment studs. The alignment posts 84a and 84b can have the same size (diameter) or can have different sizes (diameters). To help apply compression to conductive elastomer 52, coil spring structures such as coil springs 86 can be provided between back housing portion 11 and rigid portion 50'. As an example, coil springs 86 can be configured to apply an upwards force of 200 pounds or more to achieve an appropriate amount of pressure on the conductive pads that are in contact with conductive elastomer 52. The use of coil springs 86 is merely illustrative. If desired, other types of compressive applicator structures such as a screw-type applicator, a pneumatic compressor, or a hydraulic compressor can be employed.

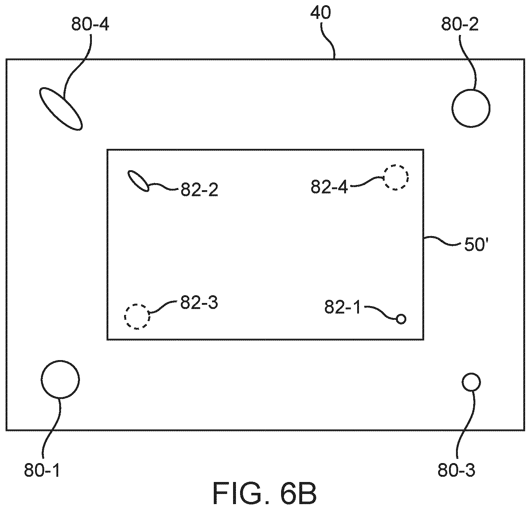

FIG. 6B is a top (plan) view showing an illustrative pattern of through holes in PCB 40 and an illustrative pattern of through holes in rigid portion 50' for receiving the alignment posts. As shown in FIG. 6B, there can be at least four holes 80-1, 80-2, 80-3, and 80-4 in printed circuit board 40. The holes 80 of FIG. 6B can represent any of holes 80 through PCB 40 shown in FIG. 6A. Hole 80-3 may be a circular through hole with a tight tolerance for fully preventing translation (e.g., hole 80-3 may be just wide enough to receive the corresponding alignment post 84a). Hole 80-4 may be a non-circular or oval/elliptical shaped slot with a tight tolerance for preventing rotation (e.g. slot 80-4 may be oriented normal to the direction of rotation). The two remaining holes 80-1 and 80-2 may be circular through holes with a loose tolerance (e.g., holes 80-1 and 80-2 may be relatively wide for receiving corresponding alignment posts for ensuring that the vertical force is evenly distributed across PCB 40). The loose tolerance holes 80-1 and 80-2 are generally wider in terms of diameter than that of the tight tolerance hole 80-3. When four holes 80 are employed, then up to four alignment posts 84a can be included within network device 10 for aligning or locating the printed circuit board 40 within the device housing 11.

There can be at least two holes 82-1 and 82-2 in rigid portion 50'. The holes 82 of FIG. 6B can represent any of holes 82 through rigid portion 50' shown in FIG. 6A. Hole 82-1 may be a circular through hole with a tight tolerance for fully preventing translation (e.g., hole 82-1 may be just wide enough to receive the corresponding alignment post 84b). Hole 82-2 may be a non-circular or oval/elliptical shaped slot with a tight tolerance for preventing rotation (e.g. slot 82-2 may be oriented normal to the direction of rotation). The two remaining holes 82-3 and 82-4 may be circular through holes with a loose tolerance (e.g., holes 82-3 and 82-4 may be relatively wide for receiving corresponding alignment posts for ensuring that the vertical force is evenly distributed across PCB 40). The loose tolerance holes 82-3 and 82-4 are optional and can be omitted from rigid portion 50'. When only two holes 82 are employed, then up to two alignment posts 84b can be included within network device 10 for aligning or locating the rigid portion 50' of flex circuit 50 within the device housing 11.

The example of FIG. 6B in which printed circuit board 40 has four alignment holes is illustrative. In other embodiments, printed circuit board 40 can have at least three alignment holes of the same size or different sizes, at least two alignment holes of the same size or different sizes, at least one alignment hole, or more than four holes of the same size or different sizes. The example of FIG. 6B in which rigid portion 50' has at least two alignment holes is illustrative. In other embodiments, rigid portion 50' can have at least three alignment holes of the same size or different sizes, at least four alignment holes of the same size or different sizes, at least one alignment hole, or more than four holes of the same size or different sizes.

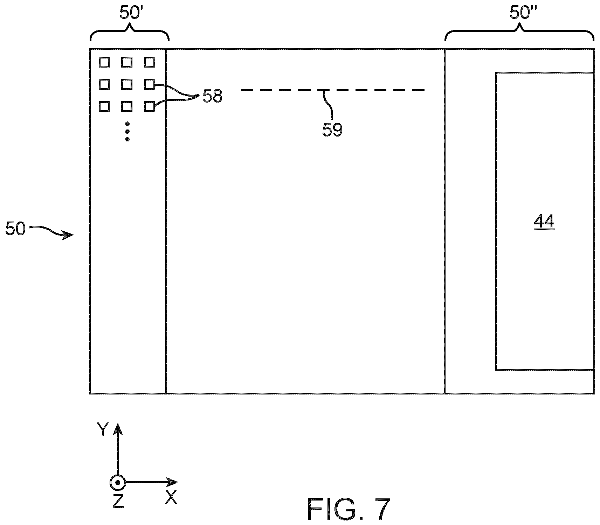

The rigid-flex circuit 50 shown in the embodiments of FIGS. 2, 5A, and 6A can represent one or more rigid-flex circuits. FIG. 7 is a top (plan) view showing a single rigid-flex circuit 50 configured to provide signal connection paths between the integrated circuit 42 and the corresponding port connectors 44 in accordance with some embodiments. As shown in FIG. 7, conductive pads such as plated pads 58 may be formed on the first rigid portion 50' of rigid-flex circuit 50 and port connectors 44 can be mounted to second rigid portion 50' of rigid-flex circuit 50. The plated pads 58 may have a pattern similar or identical to the via pattern described in connection with FIG. 4. Conductive paths or interconnects 59 formed within rigid-flex circuit 50 can electrically connect the plated pads 58 to the port connectors 44.

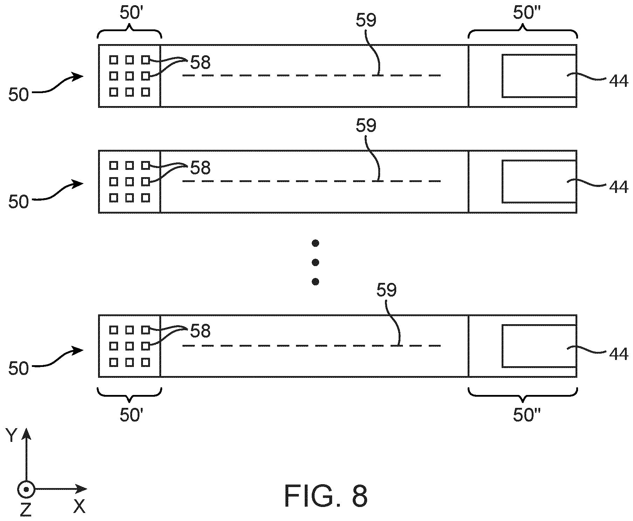

In accordance with another embodiment, FIG. 8 is a top (plan) view showing multiple rigid-flex circuits 50 configured to provide signal connection paths between the integrated circuit 42 and the corresponding port connectors 44 in accordance with some embodiments. As shown in FIG. 8, each rigid-flex circuit 50 can have plated pads 58 formed on the first rigid portion 50' and port connectors 44 mounted to second rigid portion 50". The plated pads 58 of all of the various physically adjacently rigid-flex circuits 50 may collectively form a pattern matching the via pattern described in connection with FIG. 4. Conductive paths or interconnects 59 formed within each rigid-flex circuit 50 can electrically connect the plated pads 58 to the port connectors 44.

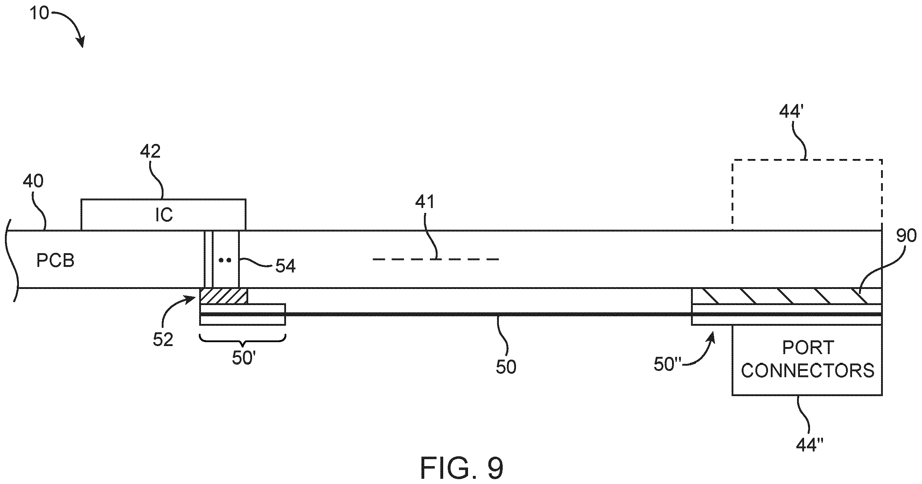

The examples of FIGS. 2, 5A, and 6A in which rigid-flex circuit 50 has a flexible portion that is bent or curved is illustrative. FIG. 9 is a side view of network device 10 having an integrated circuit 42 that is coupled to corresponding port connectors 44 via one or more rigid-flex circuits having minimal bending. As shown in FIG. 9, integrated circuit 42 can be mounted to a first side (surface) of printed circuit board 40 via an array of solder balls (e.g., a ball grid array) or other surface-mount mechanism. Integrated circuit 42 can generally represent one or more processors within device 10, such as a packet processor (as an example). Port connectors 44' can optionally be mounted to the first side of printed circuit board 40. Port connectors 44' be coupled to the first side of PCB 40 via an array of solder balls or other surface-mount mechanism. Integrated circuit (IC die or package) 42 may be communicatively (communicably) coupled to first port connectors 44-1 and second port connectors 44-2 via conductive traces 41 formed within PCB 40.

In accordance with some embodiments, integrated circuit 42 may be communicatively (communicably) coupled to additional port connectors such as port connectors 44" via rigid-flex circuit 50. Rigid-flex circuit 50 is sometimes referred to as a flex or flexible interconnect, a rigid-flex assembly, or a daughter card. Rigid-flex circuit 50 can generally represent a single rigid flex assembly as described in connection with FIG. 7 or multiple rigid flex assemblies as described in connection with FIG. 8. Rigid-flex circuit 50 has rigid portions such as a first rigid portion 50' and a second rigid portion 50" and has a flexible portion joined between the first rigid portion 50' and the second rigid portion 50". First rigid portion 50' may be mounted on the second side (surface) of printed circuit board 40. First rigid portion 50' may be coupled to the second side of printed circuit board 40 via conductive elastomeric material 52 (as an example). The conductive elastomeric material 52 is sometimes referred to as conductive elastomer. The use of conductive elastomer 52 is exemplary. If desired, other ways for mounting rigid-flex circuit 50 to a surface of PCB 40 can be employed.

Integrated circuit 42 may be communicatively coupled to corresponding conductive pads on first rigid portion 50' through conductive vias 54 formed within printed circuit board 40 (see, e.g., FIG. 4). In the example where rigid portion 50' is mounted to the underside of PCB 40 via conductive elastomer 52, there may be no solder mask at the underside of PCB 40 facing rigid portion 50' or on the top (upper) side of rigid portion 50' where conductive elastomer 52 makes contact. Conductive elastomer 52 may be conductive only in regions where the material is physically compressed. The compression of conductive elastomer 52 can be achieved by plated pads from both sides (e.g., plated pads formed on the bottom surface of PCB 40 and plated pads formed on the top surface of rigid portion 50'). A solder mask can be omitted in these areas to ensure a controlled amount of compression. The plated pads on the second side of PCB 40 facing the first rigid portion 50' and the plated pads on the first rigid portion 50' facing PCB 40 may be formed by employing an electroless nickel immersion gold (ENIG) process, an electroless nickel electroless palladium immersion gold (ENEPIG) process, or other process for avoiding corrosion and oxidation of the plated pads.

Port connectors 44" may be mounted on a bottom (lower) side of rigid portion 50" via an array of solder balls or other surface-mount mechanism. Rigid portion 50" may be secured to PCB 40 via a spacer structure 90 having a suitable height that allows the flexible portion of rigid-flex circuit 50 to exhibit minimal bending. The flexible portion of rigid-flex circuit 50 allows the additional port connectors 44" to be positioned anywhere in device 10 without the need for a mezzanine connector or near-ASIC connectors. Port connectors 44" may include one or more rows of port connectors. In embodiments where port connectors 44" represent *stacked* port connectors, port connectors 44" may include two or more rows of port connectors oriented vertically with respect to one another.

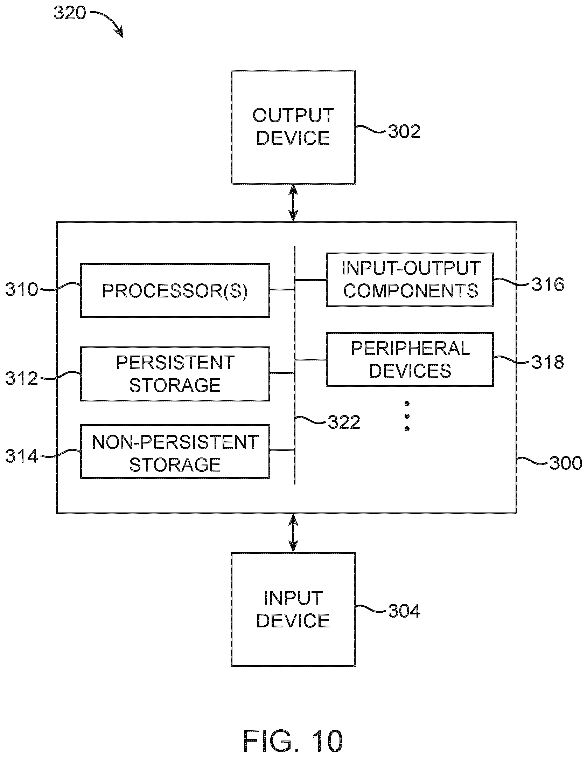

The foregoing embodiments may be made part of a larger system. FIG. 10 shows a system such as data processing system 320. Data processing system 320 may include a network device 300 optionally coupled to an input device 304 and/or an output device 302. Network device 300 may represent a network device 10 described in connection with the embodiments of FIGS. 1-9. Network device 300 may include one or more processors 310 (e.g., processing circuitry 14 of FIG. 1), storage circuitry such as persistent storage 312 (e.g., flash memory or other electrically-programmable read-only memory configured to form a solid-state drive, a hard disk drive, etc.), non-persistent storage 314 (e.g., volatile memory such as static or dynamic random-access memory, cache memory, etc.), or any suitable type of computer-readable media for storing data, software, program code, or instructions, input-output components 316 (e.g., communication interface components such as a Bluetooth^{®} interface, a Wi-Fi^{®} interface, an Ethernet interface, an optical interface, and/or other networking interfaces for connecting device 300 to the Internet, a local area network, a wide area network, a mobile network, other types of networks, and/or to another network device), peripheral devices 318, and/or other electronic components. These components can be coupled together via a system bus 322.

As an example, network device 300 can be part of a host device that is coupled to one or more output devices 302 and/or to one or more input devices 304. Input device(s) 304 may include one or more touchscreens, keyboards, mice, microphones, touchpads, electronic pens, joysticks, buttons, sensors, or any other type of input devices. Output device(s) 302 may include one or more displays, printers, speakers, status indicators, external storage, or any other type of output devices.

System 320 may be part of a digital system or a hybrid system that includes both digital and analog subsystems. System 320 may be used in a wide variety of applications as part of a larger computing system, which may include but is not limited to: a datacenter, a financial system, an e-commerce system, a web hosting system, a social media system, a healthcare/hospital system, a computer networking system, a data networking system, a digital signal processing system, an energy/utility management system, an industrial automation system, a supply chain management system, a customer relationship management system, a graphics processing system, a video processing system, a computer vision processing system, a cellular base station, a virtual reality or augmented reality system, a network functions virtualization platform, an artificial neural network, an autonomous driving system, a combination of at least some of these systems, and/or other suitable types of computing systems.

The methods and operations described above in connection with FIGS. 1-10 may be performed by the components of a network device using software, firmware, and/or hardware (e.g., dedicated circuitry or hardware). Software code for performing these operations may be stored on non-transitory computer readable storage media (e.g., tangible computer readable storage media) stored on one or more of the components of the network device. The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of the network device (e.g., processor 14 and/or processor 22 of FIG. 1, processor 310 of FIG. 10, etc.).

In accordance with an embodiment, a network device is provided that includes a printed circuit board, an integrated circuit mounted on a first side of the printed circuit board, a rigid-flex circuit having a first rigid portion, a second rigid portion, and a flexible portion joined between the first and second rigid portions, the first rigid portion of the rigid-flex circuit is mounted on a second side, opposing the first side, of the printed circuit board, and port connectors mounted on the second rigid portion of the rigid-flex circuit and electrically coupled to the integrated circuit via signal paths in the rigid-flex circuit.

In accordance with another embodiment, the printed circuit board optionally includes conductive vias for electrically coupling the integrated circuit to conductive pads on the first rigid portion of the rigid-flex circuit, and at least a portion of the first rigid portion of the rigid-flex circuit is positioned directly under the integrated circuit.

In accordance with another embodiment, the network device optionally includes conductive elastomeric material disposed between the second side of the printed circuit board and the first rigid portion of the rigid-flex circuit.

In accordance with another embodiment, the network device optionally includes first additional port connectors mounted on the first side of the printed circuit board and second additional port connectors mounted on the second side of the printed circuit board.

In accordance with another embodiment, the port connectors optionally include a first group of port connectors mounted on a first side of the second rigid portion of the rigid-flex circuit and a second group of port connectors mounted on a second side, opposing the first side, of the second rigid portion of the rigid-flex circuit.

In accordance with another embodiment, the port connectors are optionally configured to receive pluggable modules including one or more of small form-factor pluggable (SFP) modules, quad small form-factor pluggable (QSFP) modules, QSFP double density module (QSFP-DD) modules, and octal small form-factor pluggable (OSFP) modules.

In accordance with another embodiment, the port connectors are optionally configured to receive external modules including one or more of Versa Module Europa (VME) connectors, compact Peripheral Component Interconnect (PCI) connectors, compact PCI Express connectors, Small Computer System Interface (SCSI) connectors, Advanced Telecom Computing Architecture (ATCA) connectors, and Virtual Path Cross-Connector (VPX) connectors.

In accordance with another embodiment, the network device optionally includes one or more additional rigid-flex circuits mounted on the second side of the printed circuit board and configured to communicatively couple the integrated circuit to the port connectors.

In accordance with another embodiment, the network device optionally includes alignment pins configured to position the printed circuit board and the first rigid portion of the rigid-flex circuit within a housing of the network device.

In accordance with an embodiment, a network device is provided that includes a housing, a printed circuit board, a processor mounted on a first surface of the printed circuit board, port connectors, a rigid-flex circuit coupled between a second surface, opposing the first surface, of the printed circuit board and the port connectors, where the port connectors are communicatively coupled to the processor via signal paths in the rigid-flex circuit, and alignment posts extending from a portion of the housing and through one or more holes in a rigid portion of the rigid-flex circuit.

In accordance with another embodiment, the rigid portion of the rigid-flex circuit is optionally positioned directly under the processor.

In accordance with another embodiment, the alignment posts optionally extend through one or more holes in the printed circuit board.

In accordance with another embodiment, the one or more holes in the rigid portion of the rigid-flex circuit optionally include first and second circular holes having a first diameter, and a third circular hole having a second diameter smaller than the first diameter.

In accordance with another embodiment, the one or more holes in the rigid portion of the rigid-flex circuit optionally include a non-circular slot configured to prevent rotation of the rigid-flex circuit within the housing the network device when at least one of the alignment posts is inserted through the non-circular slot.

In accordance with another embodiment, the network device optionally includes additional alignment posts extending from the portion of the housing and through one or more holes in the printed circuit board.

In accordance with another embodiment, the one or more holes in the rigid portion of the rigid-flex circuit optionally include one or more circular holes and a non-circular slot, and the one or more holes in the printed circuit board optionally include one or more circular holes having a first diameter, an additional circular hole having a second diameter smaller than the first diameter, and a non-circular slot.

In accordance with another embodiment, the network device optionally includes conductive elastomer disposed between the surface of the printed circuit board and the rigid portion of the rigid-flex circuit, and compressive applicator structures disposed between the portion of the housing and the rigid portion of the rigid-flex circuit and configured to apply compressive force to the conductive elastomer.

In accordance with another embodiment, the compressive applicator structures optionally include coil springs.

In accordance with an embodiment, a network device is provided that includes a housing, a circuit board within the housing, an integrated circuit disposed on a first side of the circuit board, first port connectors disposed on the first side of the circuit board, second port connectors disposed on a second side of the circuit board, a rigid-flex circuit having a first rigid portion, a second rigid portion, and a flexible portion joining the first rigid portion and the second rigid portion, where conductive pads on the first rigid portion of the rigid-flex circuit are electrically coupled to the integrated circuit through conductive vias in the printed circuit board, third port connectors disposed on a first side of the second rigid portion of the rigid-flex circuit, and fourth port connectors disposed on a second side of the second rigid portion of the rigid-flex circuit.

In accordance with another embodiment, the network device optionally includes a plurality of alignment posts extending through two or more holes in the first rigid portion of the rigid-flex circuit and extending through two or more holes in the circuit board, conductive elastomeric material disposed between the second side of the circuit board and the first rigid portion of the rigid-flex circuit, and coil spring structures configured to apply compressive force to the conductive elastomeric material.

The foregoing is merely illustrative and various modifications can be made to the described embodiments. The foregoing embodiments may be implemented individually or in any combination.

## Claims

1. A network device comprising:
a printed circuit board;
an integrated circuit mounted on a first side of the printed circuit board;
a rigid-flex circuit having a first rigid portion, a second rigid portion, and a flexible portion joined between the first and second rigid portions, wherein the first rigid portion of the rigid-flex circuit is mounted on a second side, opposing the first side, of the printed circuit board; and
port connectors mounted on the second rigid portion of the rigid-flex circuit and electrically coupled to the integrated circuit via signal paths in the rigid-flex circuit.

2. The network device of claim 1, wherein the printed circuit board comprises conductive vias for electrically coupling the integrated circuit to conductive pads on the first rigid portion of the rigid-flex circuit, and wherein at least a portion of the first rigid portion of the rigid-flex circuit is positioned directly under the integrated circuit.

3. The network device of claim 1, further comprising:
conductive elastomeric material disposed between the second side of the printed circuit board and the first rigid portion of the rigid-flex circuit.

4. The network device of claim 1, further comprising:
first additional port connectors mounted on the first side of the printed circuit board; and
second additional port connectors mounted on the second side of the printed circuit board.

5. The network device of claim 1, wherein the port connectors comprises:
a first group of port connectors mounted on a first side of the second rigid portion of the rigid-flex circuit ;and
a second group of port connectors mounted on a second side, opposing the first side, of the second rigid portion of the rigid-flex circuit.

6. The network device of claim 1, wherein the port connectors are configured to receive pluggable modules including one or more of: small form-factor pluggable (SFP) modules, quad small form-factor pluggable (QSFP) modules, QSFP double density module (QSFP-DD) modules, and octal small form-factor pluggable (OSFP) modules.

7. The network device of claim 1, wherein the port connectors are configured to receive external modules including one or more of: Versa Module Europa (VME) connectors, compact Peripheral Component Interconnect (PCI) connectors, compact PCI Express connectors, Small Computer System Interface (SCSI) connectors, Advanced Telecom Computing Architecture (ATCA) connectors, and Virtual Path Cross-Connector (VPX) connectors.

8. The network device of claim 1, further comprising:
one or more additional rigid-flex circuits mounted on the second side of the printed circuit board and configured to communicatively couple the integrated circuit to the port connectors.

9. The network device of claim 1, further comprising
alignment pins configured to position the printed circuit board and the first rigid portion of the rigid-flex circuit within a housing of the network device.

10. The network device of claim 1, further comprising:
a housing; and
alignment posts extending from a portion of the housing and through one or more holes in the first rigid portion of the rigid-flex circuit.

11. The network device of claim 10, wherein the rigid portion of the rigid-flex circuit is positioned directly under the integrated circuit and wherein the alignment posts extend through one or more holes in the printed circuit board.

12. The network device of claim 11, wherein the one or more holes in the rigid portion of the rigid-flex circuit comprises:
first and second circular holes having a first diameter; and
a third circular hole having a second diameter smaller than the first diameter.

13. The network device of claim 10, further comprising:
conductive elastomer disposed between the surface of the printed circuit board and the first rigid portion of the rigid-flex circuit; and
compressive applicator structures disposed between the portion of the housing and the first rigid portion of the rigid-flex circuit and configured to apply compressive force to the conductive elastomer.

14. The network device of claim 1, further comprising:
first port connectors disposed on the first side of the printed circuit board;
second port connectors disposed on the second side of the printed circuit board, wherein the port connectors comprise third port connectors disposed on a first side of the second rigid portion of the rigid-flex circuit and fourth port connectors disposed on a second side of the second rigid portion of the rigid-flex circuit.

15. The network device of claim 14, further comprising:
a plurality of alignment posts extending through two or more holes in the first rigid portion of the rigid-flex circuit and extending through two or more holes in the printed circuit board;
conductive elastomeric material disposed between the second side of the circuit board and the first rigid portion of the rigid-flex circuit; and
coil spring structures configured to apply compressive force to the conductive elastomeric material.
